# EUROPEAN PATENT APPLICATION

(11) **EP 4 742 466 A2**
(43) Date of publication of application: **13.05.2026**
(21) Application number: 25213749.2
(22) Date of filing: 05.11.2025
(51) Int. Cl.: H01S 5/02315, G02B 6/42, H01S 5/02326, H01S 5/0238, H01S 5/02, H01S 5/0234, H01S 5/02345, H01S 5/0236, H01S 5/0237, H01S 5/042, H01S 5/40

(54) **CARRIER BASED LASER ASSEMBLY FOR HIGH VOLUME INTEGRATION ONTO A SUBSTRATE**

(30) Priority: 07.11.2024 US 202418940293
(71) Applicant: Ranovus Inc., Kanata, Ontario K2K 2X1 (CA)
(72) Inventor: GRZYBOWSKI, Richard, Corning, New York, 14830 (US); BEHFAR, Alex, Carlisle, Pennsylvania, 17013 (US); GREDA, Muhammad, Kanata, Ontario, K2T0L8 (CA)
(74) Representative: Zimmermann, Tankred Klaus

(57) **Abstract**

A carrier based laser assembly for high volume integration onto a substrate is provided. In particular, a device is provided that includes: a semiconductor laser comprising: a laser body comprising a laser end; a laser output at the laser end; and one or more first mating surfaces along the laser body; and a carrier comprising: a carrier body; and one or more second mating surfaces along the carrier body.

The one or more first mating surfaces and the one or more second mating surfaces are configured to slidably mate with each other. The laser body and the carrier body are configured to expose the laser output at the laser end when the one or more first mating surfaces and the one or more second mating surfaces slidably mate.

## Description

### BACKGROUND

Increasingly, photonic and/or silicon photonics based optical engines require multiple laser sources to support multiple lanes of data. Often, the need for a greater number of lasers is due to higher optical reflection tolerance, which often dictates lower output power that, in turn, supports fewer channels. This high number of lasers necessitates very high single-device laser yield in an integrated optical engine and the cumulative yield is compounded by the number of devices used. Furthermore, the lowest-loss and most cost-effective assembly methods require that the laser light source be directly attached to silicon photonics, for example, using pick and place techniques. However, the yield from pick and place techniques, which may, for example, rely on fiducials on the laser light source for accurate assembly, may still be lower than desired.

### BRIEF DESCRIPTION OF THE DRAWINGS

For a better understanding of the various examples described herein and to show more clearly how they may be carried into effect, reference will now be made, by way of example only, to the accompanying drawings in which:
FIG. 1A depicts a side view of a laser device assembly, which includes a semiconductor laser and a carrier, according to non-limiting examples.
FIG. 1B depicts a top view of the laser device assembly, according to non-limiting examples.
FIG. 1C depicts a laser-end view of the laser device assembly, according to non-limiting examples.
FIG. 2A depicts a top view of a carrier-facing side of the laser of the laser device assembly, according to non-limiting examples.
FIG. 2B depicts a top view of a portion of the carrier-facing side of the laser of the laser device assembly, showing first mating surfaces, according to non-limiting examples.
FIG. 3A depicts a top view of a laser-facing side of the carrier of the laser device assembly, according to non-limiting examples.
FIG. 3B depicts a top view of a portion of the laser-facing side of the carrier of the laser device assembly, showing second mating surfaces, according to non-limiting examples.
FIG. 4 depicts a perspective view of the laser and the carrier prior to assembly, according to non-limiting examples.
FIG. 5 depicts a perspective view of the laser and the carrier in a process of assembly, according to non-limiting examples.
FIG. 6 depicts a perspective view of the laser and the carrier further into the process of assembly, and showing a beginning of a sliding mating process, according to non-limiting examples.
FIG. 7 depicts a detailed perspective view of a portion of the laser and the carrier further into the process of assembly, and showing a continuing of the sliding mating process, focusing on an approach of the first and second mating surfaces, according to non-limiting examples.
FIG. 8 depicts a detailed perspective view of a portion of the laser and the carrier further into the process of assembly, after the sliding mating process is completed, with the first and second mating surfaces mated and/or engaged, according to non-limiting examples.
FIG. 9 depicts a bottom view of a substrate-facing side of the laser device assembly, and showing substrate mating surfaces, according to non-limiting examples.
FIG. 10 depicts a perspective view of the laser device assembly and a substrate, prior to assembly, and showing carrier mating surfaces of a cavity of the substrate, according to non-limiting examples.
FIG. 11 depicts a detailed perspective view of a portion of the laser device assembly and the substrate, showing the laser device assembly inserted into a cavity of the substrate, with the carrier resting on surfaces of the cavity, and a beginning of an assembly including another sliding mating process, according to non-limiting examples.
FIG. 12 depicts a detailed perspective view of a portion of the laser device assembly and the substrate further into the process of assembly, after the sliding mating process is completed, with the substrate and carrier mating surfaces mated and/or engaged, according to non-limiting examples.
FIG. 13 depicts a perspective view of the laser device assembly and substrate in an assembled state, according to non-limiting examples.
FIG. 14 depicts a perspective view of a device, illustrating an array of laser device assemblies mated with the substrate, which includes a plurality of cavities and waveguides, according to non-limiting examples.

Skilled artisans will appreciate that elements in the figures are illustrated for simplicity and clarity and have not necessarily been drawn to scale. For example, the dimensions of some of the elements in the figures may be exaggerated relative to other elements to help to improve understanding of embodiments of the present invention.

The apparatus and method components have been represented where appropriate by conventional symbols in the drawings, showing only those specific details that are pertinent to understanding the embodiments of the present invention so as not to obscure the disclosure with details that will be readily apparent to those of ordinary skill in the art having the benefit of the description herein.

### DETAILED DESCRIPTION

Current attaching processes of laser devices to photonic integrated circuits (PICs) are known to have a significant probability of causing the laser characteristics to degrade, or of causing failure during the operating life if the laser is not burned-in prior to attachment. While certain techniques, such as use of a carrier attached to a laser that allows burn in prior to assembly of the combined device to a substrate, may partially address this problem, accuracy of attachment of the carrier to the laser, and then later attachment of the combined carrier and laser to a substrate after burn-in, may still suffer from assembly challenges at both phases of assembly (e.g., attachment of carrier to laser, and attachment of combined carrier/laser to substrate). Use of fiducials to assist with assembly may occur, but even with fiducials, each stage of assembly still relies on accuracy of the optics of, for example, a pick and place machine.

Provided herein is a laser device assembly and substrate that provides a passive method to assemble lasers, and in particular etched facet lasers, to carriers in a fast, reliable way using existing automated manufacturing equipment that may be scaled up to build Inverted Subcarrier Laser Attach (ISLA) sub-assemblies in the millions using, for example, a sliding mating technique. Furthermore, the present specification extends the sliding mating technique to fast, reliable assembly of ISLAs onto Silicon Photonic (SiPh) optical engines. This passive assembly approach relies on photolithographically defined mating surfaces, which may also be referred to as fiducials (e.g., mechanical fiducials, as opposed to optical fiducials) added to the laser, the carrier and the substrate during their manufacture. The laser and carrier are assembled, completing an ISLA unit, which is then similarly assembled to with the substrate.

Furthermore, the devices and assembly method of the present specification may be of particular value when etched facet lasers are used. For example, because of the imprecise nature of a cleaving process, cleaved facet lasers have some uncertainty about where a cleaved laser output facet is actually located. In the present specification etched facet semiconductor lasers may be used, such that a location of the laser output facet is determined lithographically and thus is known with great accuracy. The present specification may merge the etched facet laser precision with additional mating surfaces and/or mechanical fiducials, etched on the laser upper layers and partners them with complementary mating surfaces and/or complementary mating mechanical fiducials, on a carrier substrate, thus taking advantage of the precision of photolithography on both parts to enable a fast, precise, passive alignment of the two components using existing automated assembly machines, yielding a more cost-effective ISLA subassembly.

Hence, devices and assembly method of the present specification may result in a completed ISLA unit. The carrier with the attached laser may generally enable testing and/or burn-in of the laser after attachment to the carrier. For example, the strain associated with attachment of the laser to the carrier can result in changes to the characteristics of the laser and the ability to measure these characteristics is important in achieving a high-yield SiPh device.

In most cases, pushing an ISLA toward the back end of an SiPh substrate will create a gap between the laser and the SiPh input waveguide that is too lossy to meet system requirements. Hence for the assembly of the ISLA into the SiPh substrate, devices and assembly method of the present specification may permit the ISLA to be passively aligned by pushing it forward towards an input waveguide in the SiPh substrate.

Hence, provided herein is a device comprising: a semiconductor laser comprising: a laser body comprising a laser end; a laser output at the laser end; and one or more first mating surfaces along the laser body; and a carrier comprising: a carrier body; and one or more second mating surfaces along the carrier body, the one or more first mating surfaces and the one or more second mating surfaces configured to slidably mate with each other, and the laser body and the carrier body configured to expose the laser output at the laser end when the one or more first mating surfaces and the one or more second mating surfaces slidably mate.

In some examples, the laser end may overhang an adjacent end of the carrier body.

In some examples, the one or more first mating surfaces along the laser body may be located at an end opposite the laser end, and the one or more second mating surfaces along the carrier body may be located at a respective adjacent end of the carrier body.

In some examples, the one or more first mating surfaces along the laser body may comprise one or more recesses in the laser body, the one or more second mating surfaces along the carrier body may comprise one or more protrusions from the carrier body, and respective surfaces of the one or more recesses and the one or more protrusions may be configured to slidably mate, the respective surfaces being perpendicular to a respective body.

In some examples, at least one facet of the semiconductor laser comprises an etched facet.

Furthermore, the carrier body may be generally wider than the laser body, and the device may further comprise: a substrate comprising: a cavity which accepts the laser body, the cavity including a respective laser end and an opposite end; an laser input at the respective laser end; and one or more carrier mating surfaces, wherein the carrier further comprises one or more substrate mating surfaces, wherein the one or more substrate mating surfaces and the one or more carrier mating surfaces are configured to slidably mate with each other as a combination of the semiconductor laser and the carrier, as mated, slides in the cavity towards the laser input, to align the laser output with the laser input.

In some examples, the one or more carrier mating surfaces of the substrate may be located at the respective laser end of the cavity, and the one or more substrate mating surfaces of the carrier may be located adjacent the laser end.

In some examples, the one or more carrier mating surfaces of the substrate may comprise one or more protrusions from the substrate, and the one or more substrate mating surfaces of the carrier may comprise one or more recesses in the carrier body.

In some examples, the substrate may comprise a plurality of cavities, including the cavity, to receive a plurality of respective mated semiconductor lasers and carriers.

Hence, using such mating surfaces, the semiconductor laser and the carrier may be first assembled by slidably mating the first mating surface(s) with the second mating surface(s), and the semiconductor laser may then be burned in. Assuming successful burn-in, the mated semiconductor laser and carrier may be assembled with the substrate again by slidably mating the substrate mating surface(s) and the carrier mating surfaces(s).

Furthermore, the substrate may include a plurality of cavities to receive a plurality of respective mated semiconductor lasers and carriers, that may be assembled using respective mating surfaces.

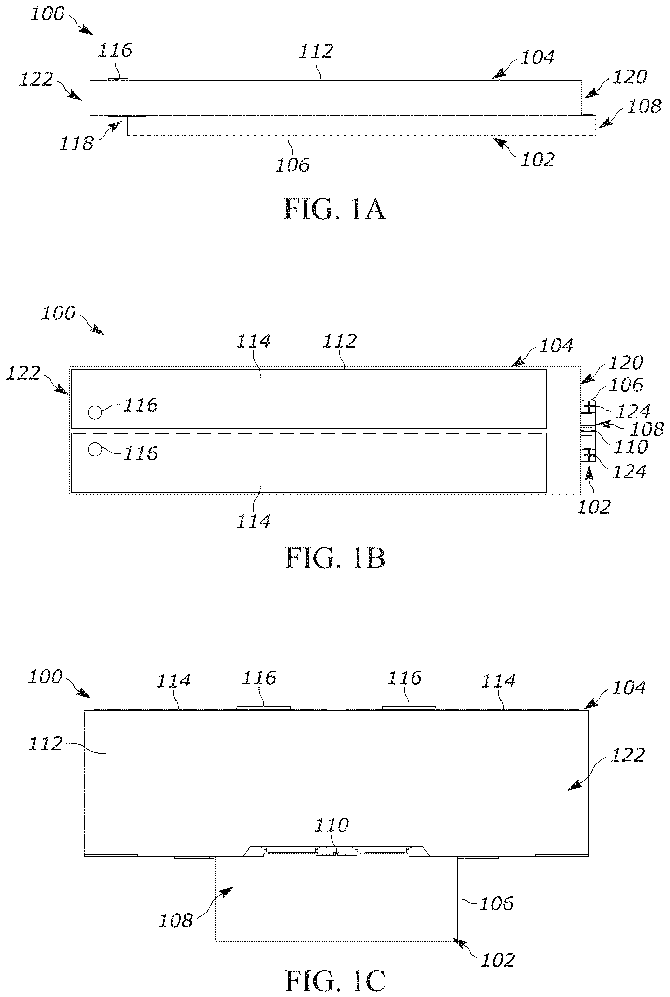

Attention is directed to FIG. 1A, FIG. 1B, and FIG. 1C which respectively depict a side view, a top view, and a laser-end view of a laser device assembly 100 (interchangeably referred to hereafter as the device 100).

The device 100 comprises a semiconductor laser 102 and a carrier 104. The semiconductor laser 102 is interchangeably referred to hereafter, for simplicity, as the laser 102. As will be explained in more detail below, the laser 102 is attached to, and/or assembled with, the carrier 104, and the laser device assembly 100 may be burned-in and/or tested prior to attachment to a substrate, for example integrated with a photonic integrated circuit (PIC).

The laser 102 generally comprises a laser body 106 comprising a laser end 108, for example, at which a laser output 110 is located, as best seen in FIG. 1B and FIG. 1C. For example, the laser output 110 may comprise an etched facet, for example, etched into the laser body 106.

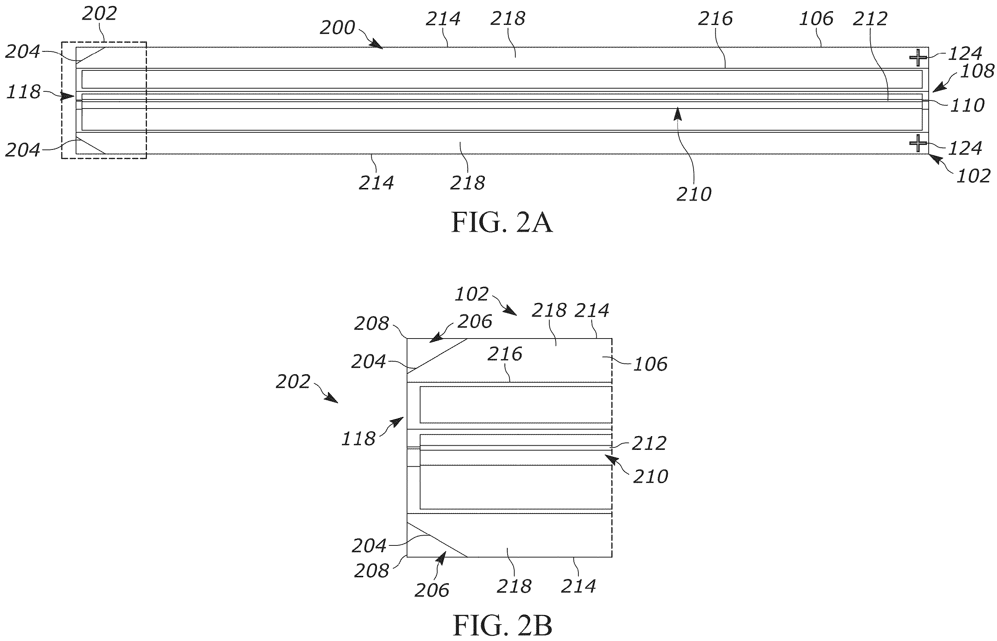

Put another way, the laser 102 is understood to include any suitable lasing device (e.g., as shown in FIG. 2A) that may be formed at the body 106 using any suitable process, and which may include a waveguide, and the like, and the laser output 110 at which the laser light emerges. For example, the body 106 may comprise a GaAs (Gallium Arsenide) base that is n-doped and has an epitaxial structure that is deposited on the GaAs substrate comprising a lower cladding that is n-doped, an active region that may be based quantum dots, a upper cladding that is p-doped, and a contact layer that is highly p-doped, and the p-doped side facing the carrier 104. In another example, the body 106 may comprise of an InP (Indium Phosphide) base with quantum wells in the active region. However, any suitable materials and/or structure of the body 106 is within the scope of the present specification.

While not described in detail, it is understood that the laser 102 may be fabricated using techniques familiar to those of skill in the art including, but not limited to photolithography, etching, and the like, though the laser 102 may be of any suitable materials and/or materials, and/or fabricated in any suitable manner.

The carrier 104 generally comprises any suitable material which may include, but is not limited to, silicon, silicon nitride, and the like, and/or any other suitable material (e.g., another suitable crystalline material, a suitable ceramic and the like), etched and/or cut and/or formed and/or cleaved into a suitable shape, though the carrier 104 may be of any suitable materials and/or materials. Hence, in a particular example, the carrier 104 may comprise a silicon carrier. The carrier 104 generally acts as a mechanical support mechanism for the laser 102 as described in more detail below.

Furthermore, the carrier 104 comprises a carrier body 112 that attaches to the laser body 106 as described herein. As also depicted, the carrier 104 comprises two electrical contacts 114 that connect to respective ends of through-carrier vias (TCVs) 116, that are understood to connect to connections to the lasing device of the laser 102, for example through the carrier body 112. Hence, while not depicted, it is understood that the device 100 includes any suitable combination of vias, connectors, and the like that enable the laser 102 to be operated by electrical communication with the contacts 114, for example when the device 100 is integrated into a PIC. Indeed, such a laser device is described in more detail in US11747554, filed May 15, 2021, claiming priority to US Patent Application No. 63/029031, files May 22, 2020, both of which are assigned to the present Applicant, and both of which are incorporated herein by reference.

For completeness, it is further understood that the laser body 106 comprises an opposite end 118, opposite the laser end 108, and the carrier body 112 comprises an end 120 adjacent the laser end 108, and a respective opposite end 122 adjacent the opposite end 118 of the laser body 106.

As best seen in FIG. 1A and FIG. 1B, the laser end 108 overhangs the adjacent end 120 of the carrier body 112.

Further for completeness, FIG. 1B depicts optical fiducials 124 (e.g., in the form of an "x" and/or a cross on opposite sides of the laser output 110, that may assist with assembly of the laser 102 and the carrier 104 using an optics based assembly system (not depicted), though reliance of an optics based assembly system on the optical fiducials 124 may be obviated, or at least reduced, due to mating surfaces of laser 102 and the carrier 104 that are next described. Hence, in the present examples, the optical fiducials 124 may be optional.

Attention is next directed to FIG. 2A and FIG. 2B, which respectively depict the laser 102, and, in particular, a carrier-facing side 200 of the laser body 106, and a portion 202 of the laser body 106 at the end 118.

In particular, as depicted in both FIG. 2A and FIG. 2B, the laser 102 further comprises one or more first mating surfaces 204 along the laser body 106. In particular, as depicted, the one or more first mating surfaces 204 along the laser body 106 are located at the end 118 opposite the laser end 108. Furthermore, as depicted, the one or more first mating surfaces 204 along the laser body 106 may comprise one or more recesses in the laser body 106.

In particular, as depicted, the one or more first mating surfaces 204 are understood to comprise respective surfaces that may be perpendicular to the laser body 106, and which, for example, are recessed relative to the remainder of the carrier-facing side 200 of the laser body 106.

Furthermore, as depicted, the one or more first mating surfaces 204 comprise a pair of perpendicular surfaces (e.g., perpendicular to other surfaces of the carrier-facing side 200 of the laser body 106) and which include respective recesses 206 at respective opposite corners 208 of the end 118, and that may be at any suitable angle to a long axis of the laser body 106. For example, also depicted in FIG. 2A is a lasing device 210 that generates light, a waveguide 212 of the lasing device 210, that extends along a long axis of the laser body 106, and a laser output 110 of the lasing device 210. Put another way, the waveguide 212 represents a long axis of the laser body 106.

The recesses 206 are understood to extend into the direction of the pages of FIG. 2A and FIG. 2B.

The one or more first mating surfaces 204 are furthermore understood to extend diagonally, for example as chamfers, and symmetrically with respect to a long axis of the laser body 106, between the end 118, and opposite sides 214 of the laser body 106 that are perpendicular to the end 118.

As also depicted in FIG. 2A and FIG. 2B, the lasing device 210 may be located at an optional pedestal 216 that extends outwards from the remainder of the laser body 106, or outward in the direction of the pages of FIG. 2A and FIG. 2B. Furthermore surfaces 218 are located on opposite sides of the pedestal 216 that extend from the first mating surfaces 204 to the laser end 108. Indeed, the optical fiducials 124 may be located at the laser end 108 on the surfaces 218. In particular, the pedestal 216, when present, is understood to be raised relative to the surfaces 218. While the pedestal 216 is optional, the pedestal 216 may assist with a sliding assembly of the laser 102 with a recess of the carrier 104 as described herein.

Furthermore, the one or more first mating surfaces 204 are understood to comprise surfaces that extend from respective surfaces 218 into respective recesses 206.

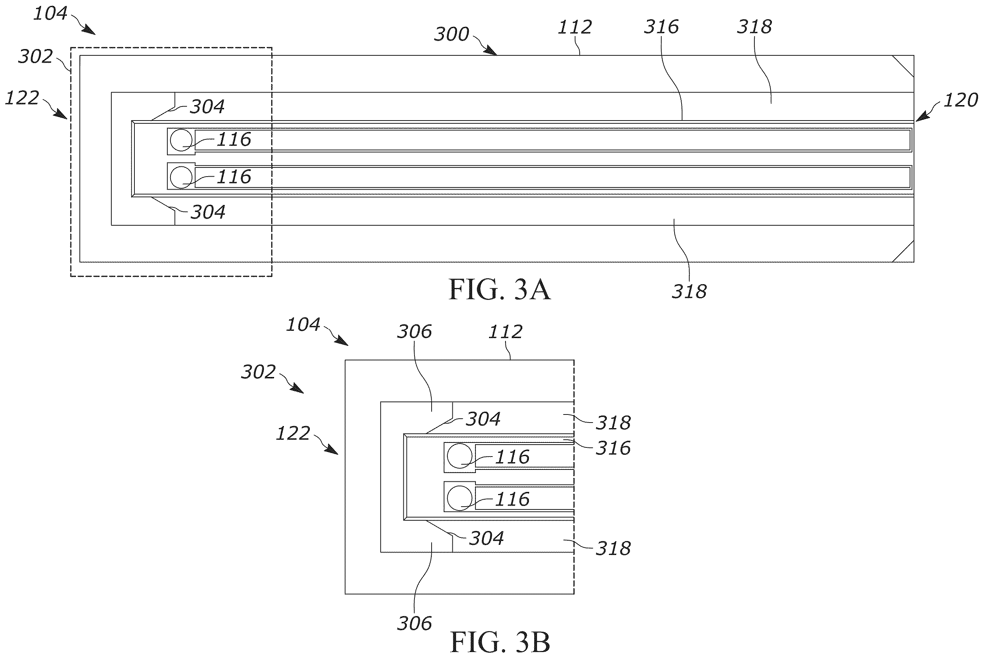

Attention is next directed to FIG. 3A and FIG. 3B, which respectively depict the carrier 104, and, in particular, a laser-facing side 300 of the carrier body 112, and a portion 302 of the carrier body 112 at the end 122.

In particular, as depicted in both FIG. 3A and FIG. 3B, the carrier 104 further comprises one or more second mating surfaces 304 along the carrier body 112. In particular, as depicted, the one or more second mating surfaces 304 along the carrier body 112 are located at the end 122, opposite the end 120. Furthermore, as depicted, the one or more second mating surfaces 304 along the carrier body 112 comprises one or more protrusions 306 from the carrier body 112.

In particular, as depicted, the one or more second mating surfaces 304 are understood to comprise respective surfaces that are perpendicular to the carrier body 112, and which, for example, are recessed relative to the remainder of the laser-facing side 300 of the carrier body 112.

Furthermore, as depicted, the one or more second mating surfaces 304 comprise a pair of perpendicular surfaces formed by the one or more protrusions 306, and that may be at any suitable angle to a long axis of the carrier body 112, which, when assembled with the laser 102, may be coincident with a long axis of the laser body 106.

The one or more protrusions 306 are understood to extend out of the direction of the pages of FIG. 3A and FIG. 3B.

The one or more second mating surfaces 304 are furthermore understood to extend diagonally, for example as chamfers, and symmetrically with respect to a long axis of the carrier body 112, and are of a complementary shape and/angle with respective first mating surfaces 204 of the laser 102. In particular, the one or more second mating surfaces 304 may comprise chamfers complementary to the chamfers of the one or more or more first mating surfaces 204.

In particular, as also depicted in FIG. 3A and FIG. 3B, the carrier body 112 comprises an optional recess 316 that extends inwards from the remainder of the carrier body 112, or inward in the direction of the pages of FIG. 3A and FIG. 3B. The recess 316 is understood to be of a size and shape that is complementary to the pedestal 216 of the laser body 106. While the pedestal 216 and the recess 316 are optional, the pedestal 216 and the recess 316 may assist with a sliding mating assembly process of the laser 102 and the carrier 104 as described herein.

Furthermore surfaces 318 are located on opposite sides of the recess 316 that extend from the second mating surfaces 304 to the end 120.

Furthermore, the one or more second mating surfaces 304 are understood to extend from a raised surface of the one or more protrusions 306 to the respective surfaces 318.

For completeness, also depicted in FIG. 3A and FIG. 3B are respective ends of the TCVs 116, that are opposite the ends of the TCVs 116 depicted in FIG. 1B. The respective ends of the TCVs 116 are understood to electrically connect to the lasing device 210 in any suitable manner when the laser 102 and the carrier 104 are assembled. Indeed, with brief reference back to FIG. 2A, the laser 102 is understood to include electrical contacts to the ends of the TCVs 116 depicted in FIG. 3A and FIG. 3B, to control the laser 102; while such electrical contacts are not depicted, they are nonetheless understood to be present.

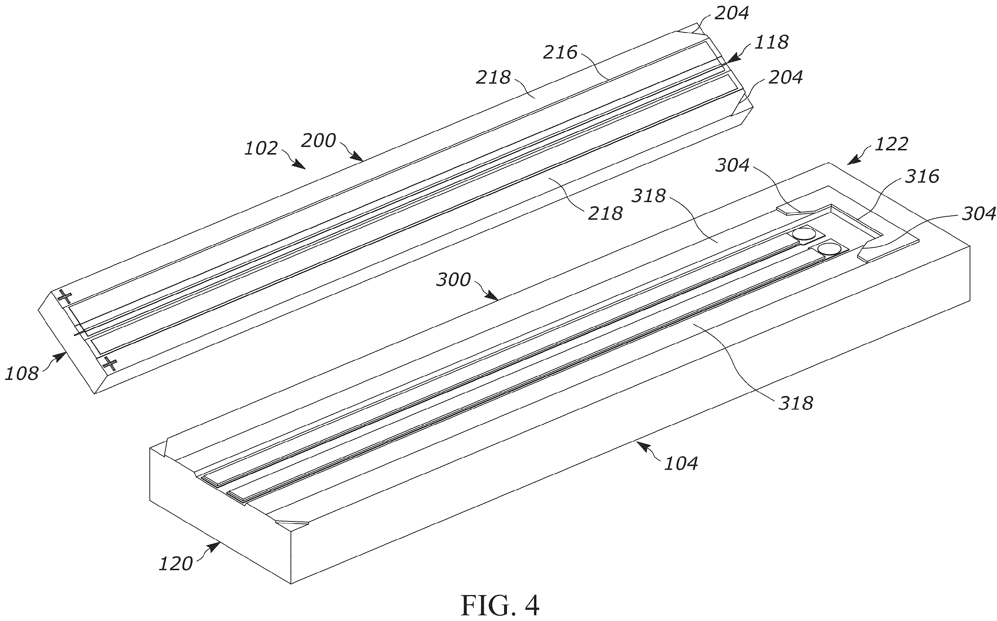

Assembly of the laser 102 and the carrier 104 will next be described with respect to FIG. 4, FIG. 5, FIG. 6, FIG. 7 and FIG. 8. In particular, FIG. 4, FIG. 5, FIG. 6, FIG. 7 and FIG. 8 are understood to show a sequence, in time, of a process for assembling the laser 102 and the carrier 104. In particular, the process depicted in FIG. 4, FIG. 5, FIG. 6, FIG. 7 and FIG. 8 may be performed by any suitable machine, and the like.

Furthermore, while for simplicity not all components of the laser 102 and the carrier 104 are indicated in FIG. 4, FIG. 5, FIG. 6, FIG. 7 and FIG. 8, they are nonetheless understood to be present.

Attention is first directed to FIG. 4, which depicts the laser 102 and the carrier 104 in perspective, and is intended merely to show the various components of the laser 102 and the carrier 104 that may interact in the assembly process. While FIG. 4 shows the carrier 104 with the laser-facing side 300 up, and the carrier-facing side 200 of the laser 102 being flipped onto the laser-facing side 300 of the carrier 104, in the assembly process, the laser 102 may be lowered onto the carrier 104 (or vice versa),

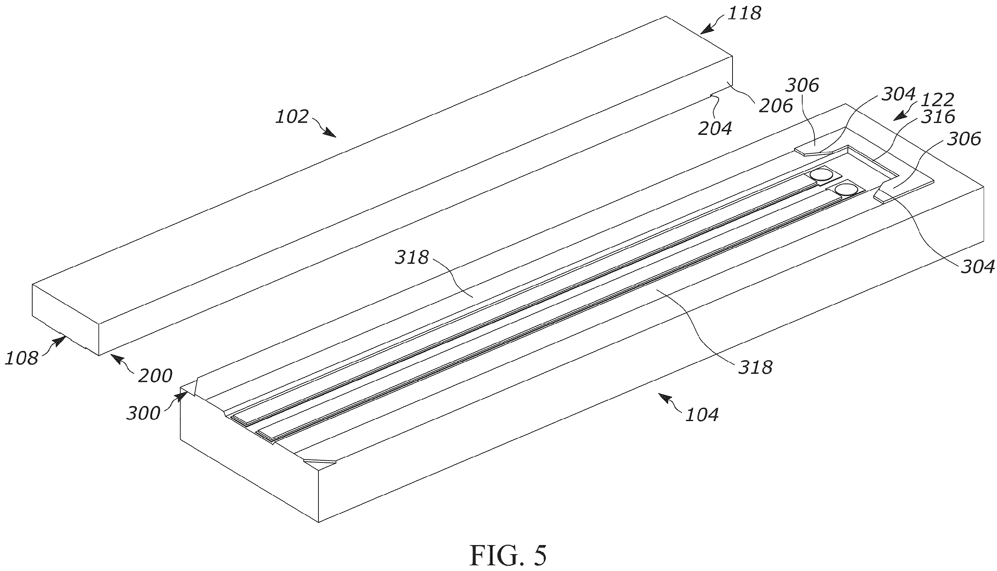

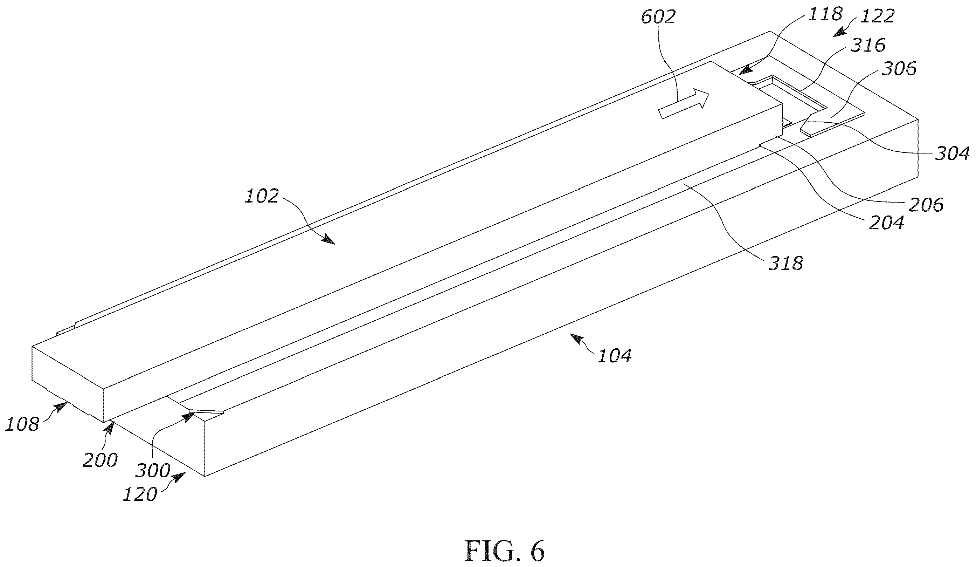

In particular, and with further reference to FIG. 5 and FIG. 6, the laser 102 is positioned with the carrier-facing side 200 facing the laser-facing side 300 of the carrier 104, and with the pedestal 216 of the laser 102 positioned to insert into the recess 316 of the carrier 104, for example with the respective ends 118, 120 about adjacent, and with the laser end 118 overhanging the adjacent end 120 of the carrier 104 by more than occurs in the assembled state. Put another way, the pedestal 216 of the laser 102 is inserted into the recess 316 of the carrier 104, but with the mating surfaces 204, 304 in an unmated position. It furthermore understood that, when the pedestal 216 of the laser 102 is inserted into the recess 316 of the carrier 104, the surfaces 218, 318 are in contact, such that the laser 102 may slide along the carrier 104, and/or the pedestal 216 may slide in the recess 316, via the surfaces 218, 318, until the mating surfaces 204, 304 encounter each other, and mate. Such sliding is represented in FIG. 6 via an arrow 602.

Hence, FIG. 5 is understood to represent a position of the laser 102 relative to the carrier 104 prior to the pedestal 216 being inserted into the recess 316, for example as the laser 102 is being lowered onto the carrier 104, and FIG. 6 is understood to represent a position of the laser 102 relative to the carrier 104 after the pedestal 216 is inserted into the recess 316.

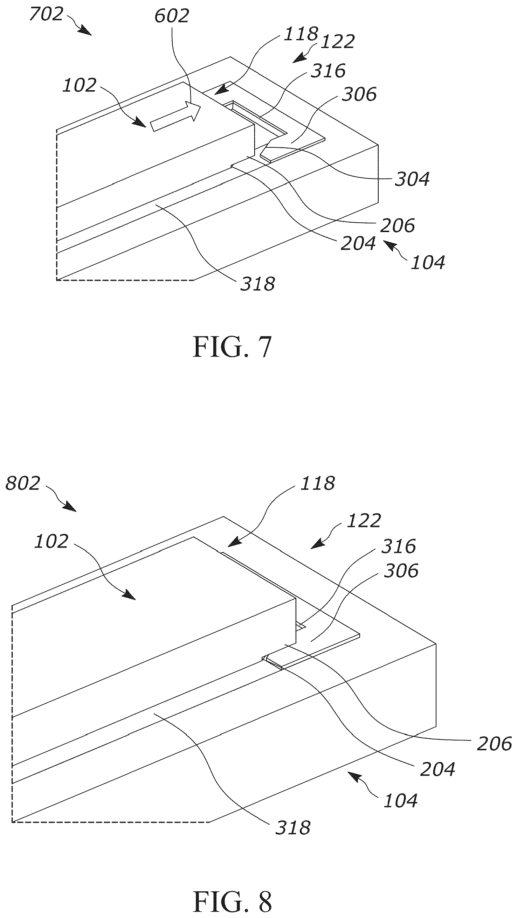

Attention is next directed to FIG. 7, which depicts a portion 702 of the laser 102 and the carrier 104 at respective adjacent ends 118, 122 while the laser 102 is being slidably mated with the carrier 104, with the arrow 602 continuing to represent a direction of movement of the laser 102. In FIG. 7, the one or more first mating surfaces 204 are understood to be approaching the one or more second mating surfaces 304.

Attention is next directed to FIG. 8, which depicts a portion 802 of the laser 102 and the carrier 104 at respective adjacent ends 118, 122 when the laser 102 is slidably mated with the carrier 104. In FIG. 8, the one or more first mating surfaces 204 are understood to be butted up against the one or more second mating surfaces 304, and with the one or more protrusions 306 being received in respective recesses 206.

Hence, it is understood that in the mated position in FIG. 8, the laser 102 and the carrier 104 are in the assembled position of the device 100 depicted in FIG. 1A,

FIG. 1B, and FIG. 1C. It is furthermore understood that the mating surfaces 204, 304 are generally respectively positioned at the laser 102 and the carrier 104 to control an amount by which the laser end 108 overhangs the adjacent end 120 of the carrier 104, for example such that the device 100 is of a size and shape to fit into a cavity of a substrate as will be described herein. Put another way, the mating surfaces 204, 304 may be generally respectively positioned at the laser 102 and the carrier 104 to control to control a position of the laser output 110 relative to the remaining components of the device 100.

Hence, the mating surfaces 204, 304 may comprise mechanical fiducials that may be produced using photolithographic techniques, and the mating surfaces 204, 304 may be precisely positioned relative to the laser output 110 such that the laser output 110 may be better positioned relative to a laser input of a substrate, as described here.

While the mating surfaces 204, 304 have been described with respect to being located at, or near, respective ends 118, 122 of the laser 102 and carrier 104, the mating surfaces 204, 304 may be at any suitable respective locations, for example respectively along the surfaces 218, 318, with sizes and/or shapes of the recesses 206 and the protrusions 306 adjusted accordingly.

Furthermore, while two of each of the mating surfaces 204, 304 are described herein, the mating surfaces 204, 304 may include as few as one pair of mating surface 204, 304, for example one first mating surface 204, and one complementary positioned second mating surface 304. However, the symmetrically arranged respective mating surfaces 204, 304 may reduce the possibility of the laser 102 twisting relative to the carrier 104 during the mating process.

While the mating surfaces 204, 304 have been described with respect to being chamfers, and as being perpendicular to respective surfaces 218, 318, the mating surfaces 204, 304 may be any suitable shape that mate, and at any suitable angle relative to the respective surfaces 218, 318, with sizes and/or shapes of the recesses 206 and the protrusions 306 adjusted accordingly.

Indeed, the mating surfaces 204, 304, the recesses 206 and the protrusions 306 may have any suitable respective complementary geometry such that the mating surfaces 204, 304 mate and, correspondingly, the recesses 206 and the protrusions 306 mate.

Furthermore, once the laser 102 and the carrier 104 are assembled, their positions may be fixed relative to one another, for example, via any suitable epoxy and/or or solder, and the like, between the laser contact pads and carrier contact pads.

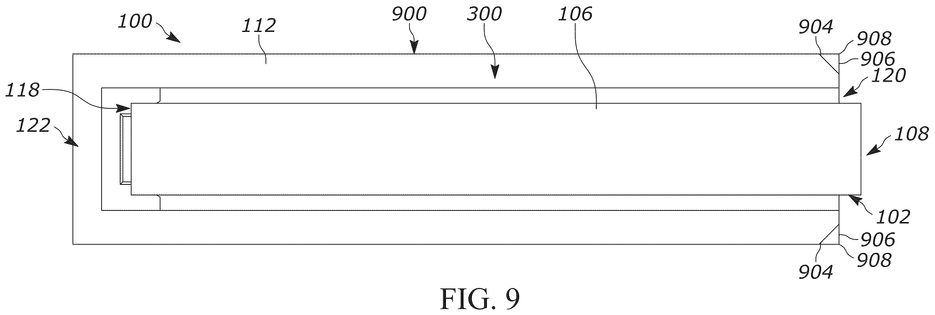

Attention is next directed to FIG. 9, which depicts a substrate facing side 900 of the device 100, that includes the laser-facing side 300 of the carrier 104. Positions of the ends 108, 118, 120, 122 are furthermore indicated.

FIG. 9 shows that the carrier body 112 is wider than the laser body 106, however such relative widths are further apparent from at least FIG. 1C, FIG. 6, FIG. 7 and FIG. 8.

As further depicted in FIG. 9, the carrier 104 may further comprise one or more substrate mating surfaces 904 at the end 120 that may comprise recesses 906, for example relative to surrounding portions of the laser-facing side 300 of the carrier 104. The substrate mating surfaces 904 may be similar to the first mating surfaces 204. In particular, as depicted, the one or more substrate mating surfaces 904 are understood to comprise respective surfaces that are perpendicular to the surrounding portions of the laser-facing side 300 of the carrier 104, and which, for example, are recessed relative to the remainder of the surrounding portions of the laser-facing side 300 of the carrier 104.

Furthermore, as depicted, the one or more substrate mating surfaces 904 comprise a pair of perpendicular surfaces (e.g., perpendicular to the surrounding portions of the laser-facing side 300 of the carrier 104) and which include respective recesses 906 at respective opposite corners 908 of the end 120, and that may be at any suitable angle (e.g. as chamfers) to a long axis of the device 100, that may be coincident with a long axis of the laser body 106. As will be described, the one or more substrate mating surfaces 904 are generally configured to mate with corresponding carrier mating surfaces of a substrate.

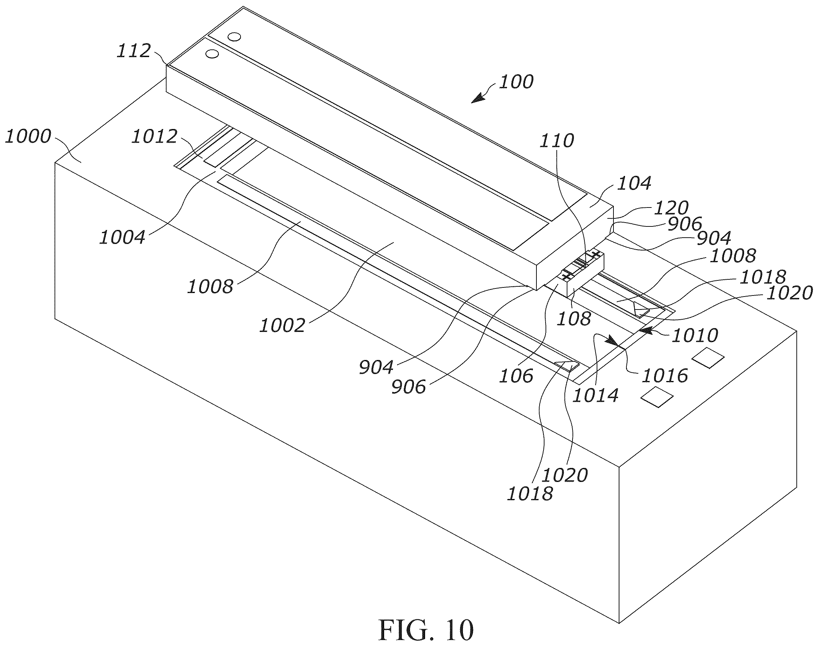

Attention is next directed to FIG. 10, which depicts the device 100 and a substrate 1000 comprising: a cavity 1002 which accepts the laser body 106. The cavity 1002 is understood to be provided with a wider portion 1004 into which the carrier body 112 at the surface of the substrate 1000 may be placed. For example, the wider portion 1004 includes surfaces 1008 onto which the carrier body 112 may rest (e.g., initially), and along which the carrier body 112 may slide as described herein. The wider portion 1004 is understood to be shallower than the remainder of the cavity 1002. Although the sidewalls of the cavity 1002 are shown as vertical, it will be understood they may be off vertical (for example, as depicted in FIG. 9 of US11747554), and/or formed by multiple surfaces that aid in the formation of the cavity 1002.

The cavity 1002 is understood to include a respective laser end 1010 and an opposite end 1012, and the cavity 1002 further includes a laser input 1014 at the respective laser end 1010, which may, for example comprise an input laser facet from which light from the laser output 110 is accepted when the device 100 is mated with the substrate 1000. Indeed, an objective of mating the device 100 with the substrate 1000 (e.g., and of mating the laser 102 to the carrier 104), may be to align the laser output 110 with the laser input 1014 such that light from the lasing device 210 enters a waveguide 1016 (e.g., an input waveguide) of the substrate 1000, with the laser input 1014 comprising an input to the waveguide 1016. While for simplicity the waveguide 1016 is drawn on the substrate 1000 herein, the waveguide 1016 may be interior to the substrate 1000. The placement of surfaces of 218, 318, as well as the location of the laser output 110, are selected and implemented through semiconductor processes such as lithography and etching. The placement of the substrate surfaces 1008 and the one or more substrate mating surfaces 904 as well as the laser input 1014 are also selected and implemented through semiconductor processes such as lithography and etching. As such, the alignment of the laser output 110 with the laser input 1014 may be achieved with very high precision, enabling low loss coupling the laser light output 110 to the laser input 1014. The substrate 1000 may, in some examples, comprise a silicon substrate (e.g., a SiPh substrate), though the substrate 1000 may be of any suitable material(s).

To facilitate the mating of the device 100 with the substrate, the substrate 1000 may comprise, as depicted, one or more carrier mating surfaces 1018, which may comprise respective protrusions 1020, such that the one or more carrier mating surfaces 1018 extend perpendicularly between the respective protrusions 1020 and respective surfaces 1008. Put another way, the respective protrusions 1020 may extend from respective surfaces 1008. The one or more carrier mating surfaces 1018 may comprise chamfers complementary to the chamfers of the one or more or more substrate mating surfaces 904.

Furthermore, as depicted, the one or more carrier mating surfaces 1018 of the substrate 1000 may be located at the respective laser end 1010 of the cavity 1002, and, correspondingly, the one or more substrate mating surfaces 904 of the carrier 104 may be located adjacent the laser end 120 of the carrier 104, such that the mating surfaces 904, 1018 are generally located in complementary positions to mate with each other.

In particular, the one or more substrate mating surfaces 904 and the one or more carrier mating surfaces 1018 are configured to slidably mate with each other, as a combination of the semiconductor laser 102 and the carrier 104 (e.g., as mated to form the device 100), slides in the cavity 1002 towards the laser input 1014, to align the laser output 110 with the laser input 1014.

For example, as the one or more carrier mating surfaces 1018 of the substrate 1000 may comprise one or more protrusions 1020 from the substrate 1000, the one or more substrate mating surfaces 904 of the carrier 104 may comprise one or more recesses 906 in the carrier body 112, and a protrusion 1020 may mate with a respective recess 906.

In general, a main (e.g., deepest) portion of the cavity 1002 may be longer than the laser body 106, such that, when the laser body 106 is placed into the cavity 1002, with the laser end 108 of the laser body 106 oriented towards the respective laser end 1010 of the cavity 1002, and the carrier body 112 rests on the surfaces 1008 of the wider (e.g., and not as deep) portion 1004 of the cavity 1002, the laser body 106 may slide towards the laser end 1010.

Similarly, a depth of the wider portion 1004 of the cavity 1002 is selected such that, when the laser body 106 is placed into the cavity 1002, with the laser end 108 of the laser body 106 oriented towards the respective laser end 1010 of the cavity 1002, the laser output 110 is aligned with the laser input 1014, for example along an axis defined by the waveguide 1016.

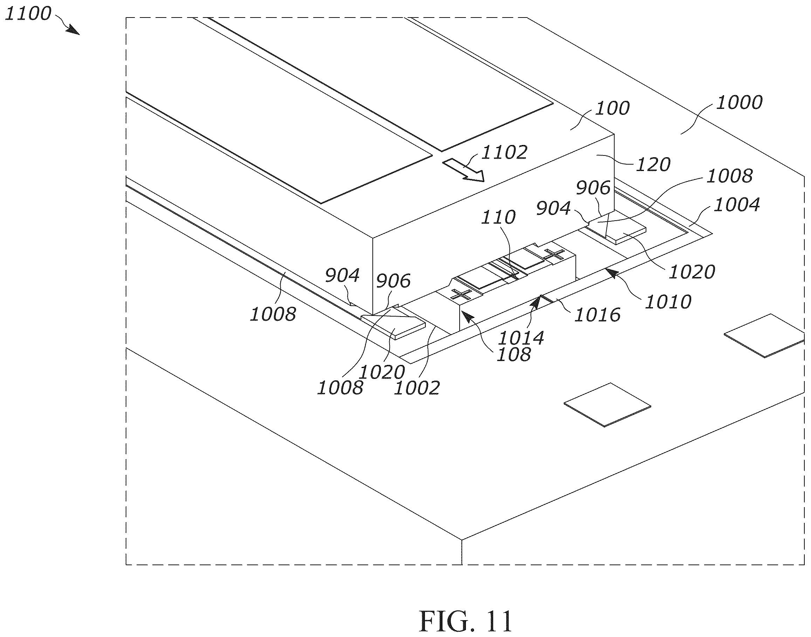

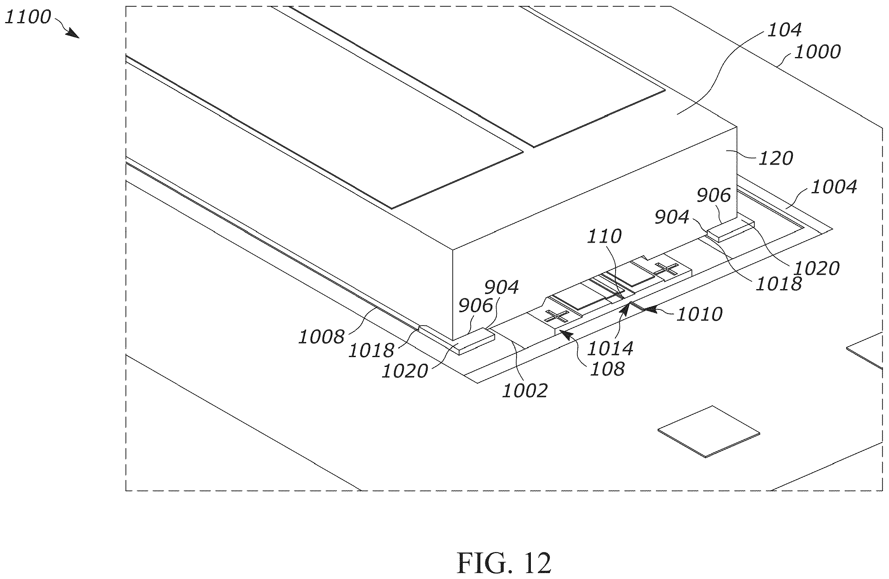

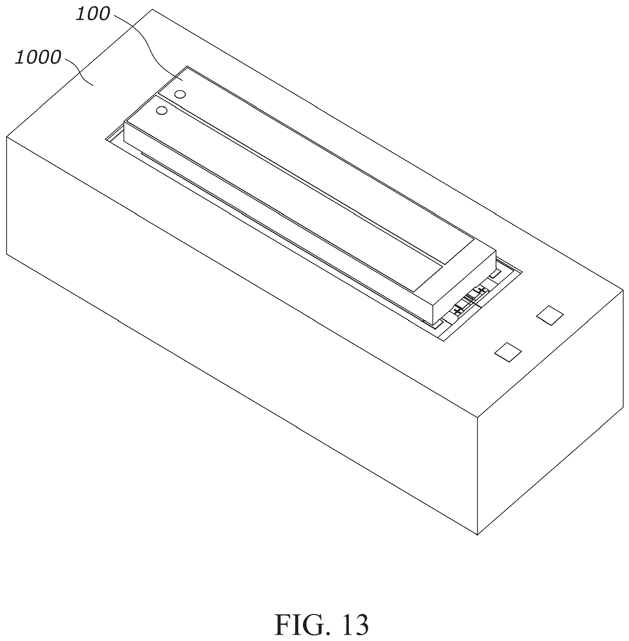

For example, attention is next directed to FIG. 11. FIG. 12, and FIG. 13, which, with FIG. 10, represents a sequence, in time, of a process for assembling the device 100 with the substrate 1000. In particular, the process depicted in FIG. 10, FIG. 11, FIG. 12 and FIG. 13 may be performed by any suitable machine, and the like, while in FIG. 11 and FIG. 12, the waveguide 1016 is omitted for simplicity, the waveguide 1016 is nonetheless understood to be present.

FIG. 11 is understood to follow from FIG. 10. In particular, FIG. 11 depicts a portion 1100 of the device 100 and the substrate 1000 at the ends 108, 120, 1010. Relative to FIG. 10, the device 100 has been placed into the cavity 1002, with the laser 102 residing in the deeper portion of the cavity 1002, and with the carrier 104 residing on the surfaces 1008, located in the wider portion 1004 on either side of the cavity 1002. The device 100 is furthermore understood to be placed into the cavity 1002 with the mating surfaces 904, 1018 separated from each other, so that the device 100 may slide, on the surfaces 1008, for example in the cavity 1002, towards the laser end 1010, until the mating surfaces 904, 1018 encounter each other, and mate. Such sliding is represented in FIG. 11 via an arrow 1102.

Attention is next directed to FIG. 12, which depicts the portion 1100 with the device 100 in a mated and/or assembled position relative to the substrate 1000. The device 100 and the substrate 1000 are further depicted in the assembled position in a perspective view in FIG. 13. Put another way, in FIG. 12 and FIG. 13, the device 100 is slidably mated with the substrate 1000. In particular, as best seen in FIG. 12, the one or more substrate mating surfaces 904 are understood to be butted up against the one or more carrier mating surfaces 1018, and with the one or more protrusions 1020 being received in respective recesses 906.

It is furthermore understood that the mating surfaces 904, 1018 are generally respectively positioned at the device 100 and the substrate 1000 to control a distance between the laser output 110 and the laser input 1014, which may be butted up against each other, and/or separated by any suitable distance.

Hence, the mating surfaces 904, 1018 may comprise mechanical fiducials that may be produced using photolithographic techniques, and the mating surfaces 904, 1018 may be precisely positioned relative to the laser output 110 and the laser input 1014 such that the laser output 110 may be better positioned relative to the laser input 1014.

While the mating surfaces 904, 1018 have been described with respect to being located at, or near, the ends 108, 120 of the device 100, and the laser end 1010 of the cavity 1002, the mating surfaces 904, 1018 may be at any suitable respective locations, for example respectively along the substrate facing side 900, and the surfaces 1008, with sizes and/or shapes of the recesses 906 and the protrusions 1020 adjusted accordingly.

Furthermore, while two of each of the mating surfaces 904, 1018 are described herein, the mating surfaces 904, 1018 may include as few as one pair of mating surfaces 904, 1018, for example one substrate mating surface 904, and one complementary positioned carrier mating surface 1018. However, the symmetrically arranged respective mating surfaces 904, 1018 may reduce the possibility of the device 100 twisting relative to the substrate 1000 during the mating process.

While the mating surfaces 904, 1018 have been described with respect to being perpendicular to respective surfaces of the substrate facing side 900 and the surfaces 1008, the mating surfaces 904, 1018 may be at any suitable angle relative to the respective surfaces, with sizes and/or shapes of the recesses 906 and the protrusions 1020 adjusted accordingly.

While the mating surfaces 904, 1018 been described with respect to being chamfers, the mating surfaces 904, 1018 may be any suitable shape that mate, with sizes and/or shapes of the recesses 906 and the protrusions 1020 adjusted accordingly.

Indeed, the mating surfaces 904, 1018, the recesses 906 and the protrusions 1020 may have any suitable respective complementary geometry such that the mating surfaces 904, 1018 mate and, correspondingly, the recesses 906 and the protrusions 1020 mate.

Furthermore, once the device 100 and the substrate 1000 are assembled as described, their positions may be fixed relative to one another, for example, via any suitable epoxy and/or solder, and the like.

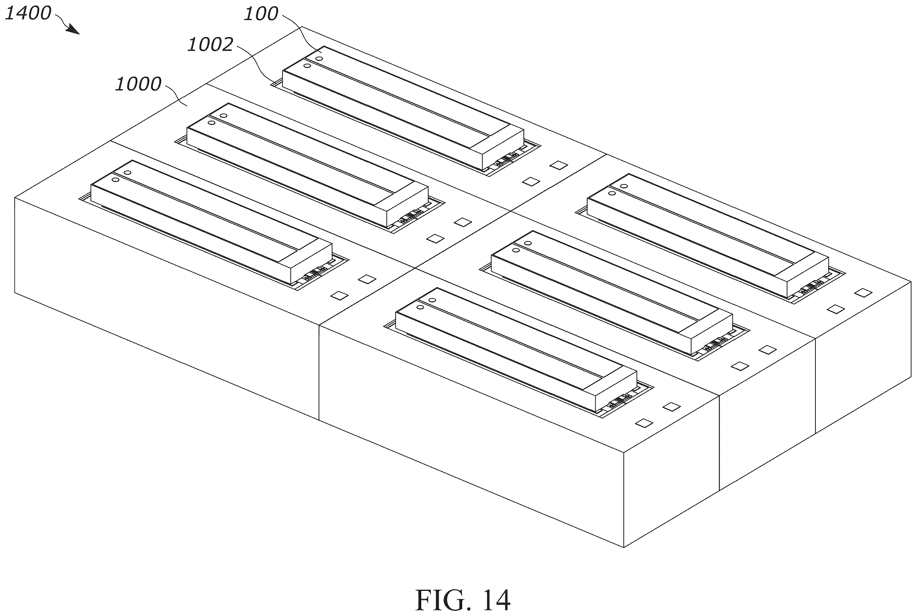

Heretofore, it is understood that only a portion of the substrate 1000 has been depicted, and that the substrate 1000 may include a plurality of cavities 1002 and respective laser inputs 1014 and respective waveguides 1016 that may be mated with respective devices 100, for example, after the devices 100 are assembled and burned in. Such a device 1400 is depicted in FIG. 14, the device 1400 comprising the substrate 1000 having a plurality of cavities 1002, with respective devices 100 assembled into the cavities 1002 as described herein. While only one device 100 and cavity 1002 are indicated for simplicity, it is understood that the device 1400 comprises an array of 2 by 3 devices 100 assembled with the substrate 1000 are depicted. Furthermore, each respective device 100 is understood to be controllable to output laser light from a respective laser output 110 into a respective laser input 1014 and waveguide 1016. Indeed, by assembling the devices 100 using mating surfaces as described herein, and by assembling the devices 100 with the substrate 1000 using respective mating surfaces as described herein, yield of the devices 100 may increase relative to when mating surfaces are not used. The device 1400 may comprise a SiPh optical engine.

In this specification, elements may be described as "configured to" perform one or more functions or "configured for" such functions. In general, an element that is configured to perform or configured for performing a function is enabled to perform the function, or is suitable for performing the function, or is adapted to perform the function, or is operable to perform the function, or is otherwise capable of performing the function.

It is understood that for the purpose of this specification, language of "at least one of X, Y, and Z" and "one or more of X, Y and Z" can be construed as X only, Y only, Z only, or any combination of two or more items X, Y, and Z (e.g., XYZ, XY, YZ, XZ, and the like). Similar logic can be applied for two or more items in any occurrence of "at least one..." and "one or more..." language.

The terms "about", "substantially", "essentially", "approximately", and the like, are defined as being "close to", for example as understood by persons of skill in the art. In some examples, the terms are understood to be "within 10%," in other examples, "within 5%", in yet further examples, "within 1%", and in yet further examples "within 0.5%".

Persons skilled in the art will appreciate that in some examples, the functionality of devices and/or methods and/or processes described herein can be implemented using pre-programmed hardware or firmware elements (e.g., application specific integrated circuits (ASICs), electrically erasable programmable read-only memories (EEPROMs), etc.), or other related components. In other examples, the functionality of the devices and/or methods and/or processes described herein can be achieved using a computing apparatus that has access to a code memory (not shown) which stores computer-readable program code for operation of the computing apparatus. The computer-readable program code could be stored on a computer readable storage medium which is fixed, tangible and readable directly by these components, (e.g., removable diskette, CD-ROM, ROM, fixed disk, USB drive). Furthermore, it is appreciated that the computer-readable program can be stored as a computer program product comprising a computer usable medium. Further, a persistent storage device can comprise the computer readable program code. It is yet further appreciated that the computer-readable program code and/or computer usable medium can comprise a non-transitory computer-readable program code and/or non-transitory computer usable medium. Alternatively, the computer-readable program code could be stored remotely but transmittable to these components via a modem or other interface device connected to a network (including, without limitation, the Internet) over a transmission medium. The transmission medium can be either a non-mobile medium (e.g., optical and/or digital and/or analog communications lines) or a mobile medium (e.g., microwave, infrared, free-space optical or other transmission schemes) or a combination thereof.

Persons skilled in the art will appreciate that there are yet more alternative examples and modifications possible, and that the above examples are only illustrations of one or more embodiments. The scope, therefore, is only to be limited by the claims appended hereto.

## Claims

1. A device comprising:
a semiconductor laser comprising: a laser body comprising a laser end; a laser output at the laser end; and one or more first mating surfaces along the laser body; and
a carrier comprising: a carrier body; and one or more second mating surfaces along the carrier body,
the one or more first mating surfaces and the one or more second mating surfaces configured to slidably mate with each other, and
the laser body and the carrier body configured to expose the laser output at the laser end when the one or more first mating surfaces and the one or more second mating surfaces slidably mate.

2. The device of claim 1, wherein the laser end overhangs an adjacent end of the carrier body.

3. The device of claim 1, wherein the one or more first mating surfaces along the laser body are located at an end opposite the laser end, and the one or more second mating surfaces along the carrier body are located at a respective adjacent end of the carrier body.

4. The device of claim 1, wherein the one or more first mating surfaces along the laser body comprises one or more recesses in the laser body,
wherein the one or more second mating surfaces along the carrier body comprises one or more protrusions from the carrier body, and
wherein respective surfaces of the one or more recesses and the one or more protrusions are configured to slidably mate, the respective surfaces being perpendicular to a respective body.

5. The device of claim 1, wherein at least one facet of the semiconductor laser comprises an etched facet.

6. The device of claim 1, wherein the carrier body is wider than the laser body, the device further comprising: a substrate comprising: a cavity which accepts the laser body, the cavity including a respective laser end and an opposite end; a laser input at the respective laser end; and one or more carrier mating surfaces,
wherein the carrier further comprises one or more substrate mating surfaces,
wherein the one or more substrate mating surfaces and the one or more carrier mating surfaces are configured to slidably mate with each other as a combination of the semiconductor laser and the carrier, as mated, slides in the cavity towards the laser input, to align the laser output with the laser input.

7. The device of claim 6, wherein the one or more carrier mating surfaces of the substrate are located at the respective laser end of the cavity, and the one or more substrate mating surfaces of the carrier are located adjacent the laser end.

8. The device of claim 6, wherein the one or more carrier mating surfaces of the substrate comprises one or more protrusions from the substrate, and
wherein the one or more substrate mating surfaces of the carrier comprises one or more recesses in the carrier body.

9. The device of claim 6, wherein the substrate comprises a plurality of cavities, including the cavity, to receive a plurality of respective mated semiconductor lasers and carriers.
